# EUROPÄISCHE PATENTSCHRIFT

(11) **EP 2 874 846 B1**
(45) Veröffentlichungstag und Bekanntmachung des Hinweises auf die Patenterteilung: **14.09.2016**
(21) Anmeldenummer: 13736779.3
(22) Anmeldetag: 09.07.2013
(51) Int. Cl.: B60K 37/02, B60Q 3/04, G09G 3/34, H03K 17/96

(54) **ANZEIGEVORRICHTUNG EINES KRAFTWAGENS SOWIE VERFAHREN ZUM BETREIBEN EINER SOLCHEN ANZEIGEVORRICHTUNG**
DISPLAY DEVICE OF A MOTOR VEHICLE AND METHOD FOR OPERATING A DISPLAY DEVICE OF THIS TYPE
DISPOSITIF D'AFFICHAGE D'UN VÉHICULE À MOTEUR AINSI QUE PROCÉDÉ DE COMMANDE D'UN TEL DISPOSITIF D'AFFICHAGE

(30) Priorität: 20.07.2012 DE 102012014351
(43) Veröffentlichungstag der Anmeldung: 27.05.2015
(73) Patentinhaber: Audi AG, 85045 Ingolstadt (DE)
(72) Erfinder: SCHWANTNER, Stephan, 85125 Haunstetten Eichstätt (DE); WALL, Christian, 85122 Hitzhofen (DE)
(74) Vertreter: Brandt, Kai
(86) Internationale Anmeldenummer: PCT/EP2013/002012
(87) Internationale Veröffentlichungsnummer: WO 2014/012634

(56) Entgegenhaltungen:
- WO-A1-2005/025921
- DE-A1- 4 212 361
- DE-A1- 4 305 446
- DE-A1-102006 005 418
- DE-C1- 4 336 669

## Beschreibung

Die Erfindung betrifft eine Anzeigevorrichtung eines Kraftwagens gemäß dem Oberbegriff des Patentanspruchs 1 sowie ein Verfahren zum Betreiben einer Anzeigevorrichtung gemäß dem Oberbegriff des Patentanspruchs 8.

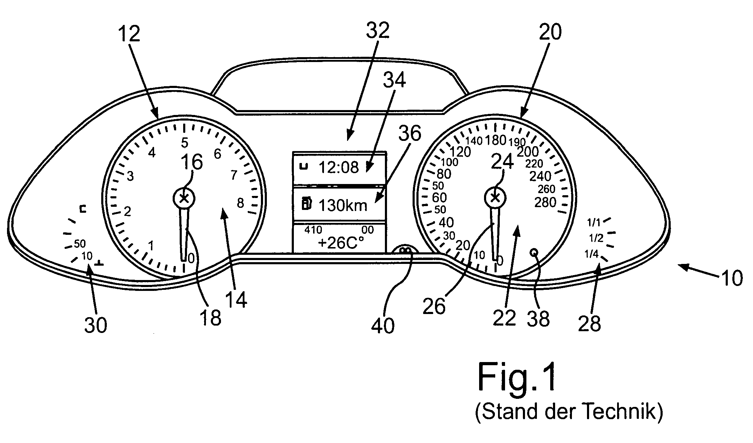

Derartige Anzeigevorrichtungen von Kraftwagen sowie Verfahren zum Betreiben solcher Anzeigevorrichtungen sind aus dem Serienbau von Kraftwagen hinlänglich bekannt. Fig. 1 zeigt eine solche Anzeigevorrichtung 10 gemäß dem Stand der Technik in einer schematischen Vorderansicht. Die Anzeigevorrichtung 10 wird üblicherweise auch als Kombiinstrument bezeichnet und bei Personenkraftwagen der Marke AUDI verwendet.

Die Anzeigevorrichtung 10 umfasst ein erstes Anzeigeelement 12 in Form eines sogenannten Drehzahlmessers, mittels welchem Werte einer Drehzahl einer Verbrennungskraftmaschine zum Antreiben des Personenkraftwagens anzeigbar sind. Dazu umfasst das Anzeigeelement 12 eine Werteskala 14 mit den Werten für die Drehzahl sowie einen um eine Schwenkachse 16 entlang der Werteskala 14 verschwenkbaren Zeiger 18, welcher den aktuellen Wert der Drehzahl anzeigt. Vorliegend ist die Verbrennungskraftmaschine deaktiviert, so dass der Wert der Drehzahl 0 beträgt.

Die Anzeigevorrichtung 10 umfasst ein zweites Anzeigeelement 20 in Form eines sogenannten Tachometers, mittels welchem Werte einer Fahrzeuggeschwindigkeit des Personenkraftwagens anzeigbar sind. Dazu umfasst das Anzeigeelement 20 eine Werteskala 22 mit Werten der Fahrzeuggeschwindigkeit sowie einen um eine Schwenkachse 24 entlang der Werteskala 22 verschwenkbaren Zeiger 26 zum Anzeigen des aktuellen Werts der Fahrzeuggeschwindigkeit. Vorliegend steht der Personenkraftwagen, so dass der Wert der Fahrzeuggeschwindigkeit 0 beträgt.

Die Anzeigevorrichtung 10 umfasst auch ein drittes Anzeigeelement 28 zum Anzeigen von Werten, die einen Füllstand eines Kraftstofftanks des Personenkraftwagens charakterisieren. Darüber hinaus ist ein viertes Anzeigeelement 30 zum Anzeigen von Werten einer Kühlflüssigkeitstemperatur oder eine Schmieröltemperatur vorgesehen.

Weiterhin umfasst die Anzeigevorrichtung 10 ein fünftes Anzeigeelement 32, welches einen Flüssigkristallbildschirm zum Anzeigen von unterschiedlichen Werten umfasst. Einer dieser Werte ist vorliegend die aktuelle Uhrzeit 34. Ein weiterer dieser Werte ist eine Reichweite 36, über welche der Personenkraftwagen von der Verbrennungskraftmaschine unter Nutzung einer im Kraftstofftank verbleibenden Menge des Kraftstoffes noch angetrieben werden kann.

Die Anzeigeelemente 12, 20, 28, 30 32 umfassen jeweils wenigstens ein Leuchtelement zum Einstellen einer Anzeigehelligkeit der jeweiligen Anzeigeelemente 12, 20, 28, 30, 32. Um für den Fahrer des Personenkraftwagens angenehme Helligkeitsbedingungen zu schaffen, wird die jeweilige Anzeigehelligkeit mittels des entsprechenden Leuchtelements derart eingestellt, dass die Anzeigeelemente 12, 20, 28, 30, 32 zumindest im Wesentlichen gleiche Anzeigehelligkeiten aufweisen.

Die Anzeigevorrichtung 10 (Kombiinstrument) umfasst auch eine in Fig. 1 nicht erkennbare Erfassungseinrichtung mit wenigstens einem Erfassungselement 38 zum Erfassen einer Umgebungshelligkeit einer Umgebung der Anzeigeelemente 12, 20, 28, 30, 32.

Im Rahmen des Verfahrens zum Betreiben der Anzeigevorrichtung 10 wird dabei die jeweilige Anzeigehelligkeit in Abhängigkeit von der erfassten Umgebungshelligkeit eingestellt. Mit anderen Worten ist die jeweilige Anzeigehelligkeit mittels des jeweiligen Leuchtelements in Abhängigkeit von der erfassten Umgebungshelligkeit einstellbar. Bei dem Erfassungselement 38 handelt es sich beispielsweise um eine Fotodiode oder um einen Fototransistor.

Die Anzeigevorrichtung 10 umfasst auch ein Betätigungselement 40, welches vorliegend als Drückknopf ausgebildet ist. Durch Drücken des Betätigungselements 40, beispielsweise durch den Fahrer des Personenkraftwagens, kann eine Funktion des Personenkraftwagens und vorliegend der Anzeigevorrichtung 10 bewirkt werden. Vorliegend ist diese Funktion, dass durch Betätigen, d.h. Drücken des Betätigungselements 40, ein Wert eines Kilometerstands des Personenkraftwagens auf 0 gestellt wird. Bei dem Kilometerstand handelt es sich um einen sogenannten Tageskilometerstand, welcher eine Strecke in Kilometern angibt, die der Personenkraftwagen seit letztmaligem Betätigen des Betätigungselements 40 zurückgelegt hat. Mit anderen Worten kann der Kilometerstand mittels des mechanischen Betätigungselements 40 auf 0 gestellt werden.

Das Verwenden des mechanischen Betätigungselements 40 zum Bewirken dieser Funktion erfordert sowohl ein Entwickeln als auch ein Herstellen des Betätigungselements 40, was zu relativ hohen Kosten der Anzeigevorrichtung 10 führt.

Die DE 100 21 101 B4 offenbart eine Anzeigevorrichtung in einem Fahrzeug, wobei in der Anzeigevorrichtung eine Vielzahl von Informationen anzeigbar ist. Die Anzeigevorrichtung ist von verschieden farbigen Lichtquellen, insbesondere Kaltkatodenfluoreszenzlampen, beleuchtet. In der Anzeigevorrichtung ist eine Flüssigkristallzelle angeordnet, wobei die verschieden farbigen Lichtquellen von einer Steuereinheit ansteuerbar sind. Durch die Steuereinheit ist mindestens ein Fahrtparameter des Fahrzeugs erfassbar und auswertbar, wobei eine Helligkeit der verschieden farbigen Lichtquelle in Abhängigkeit von dem Fahrtparameter durch die Steuereinheit veränderbar ist. Dabei ist die Flüssigkristallzelle durch die verschieden farbigen Lichtquellen hinterleuchtbar.

Weiterhin ist aus der DE 35 01 594 U1 ein Cockpitinstrument für Kraftfahrzeuge zur Anzeige von Geschwindigkeit und/oder Ladedruck und/oder Drehzahl und/oder Benzinanzeige und/oder Öldruck und/oder Öltemperatur und/oder Lichtmaschinenspannung und/oder Batterieladezustand oder dergleichen mit einem Gehäuse bekannt, welches durch eine Frontscheibe verschlossen ist und in dem sich ein Messwerk befindet. Dabei ist vorgesehen, dass an oder auf der Frontscheibe mehrere Leuchtdioden gleichen Typs in linienförmiger Anordnung zueinander befestigt sind.

Die DE 42 12 361 zeigt eine Anzeigevorrichtung mit den Merkmalen des Oberbegriffs des Anspruchs 1.

Es ist Aufgabe der vorliegenden Erfindung, eine Anzeigevorrichtung eines Kraftwagens sowie ein Verfahren zum Betreiben einer solchen Anzeigevorrichtung der eingangs genannten Art derart weiterzuentwickeln, dass die Anzeigevorrichtung besonders geringe Kosten aufweist.

Diese Aufgabe wird durch eine Anzeigevorrichtung eines Kraftwagens mit den Merkmalen des Patentanspruchs 1 sowie durch ein Verfahren zum Betreiben einer solchen Anzeigevorrichtung mit den Merkmalen des Patentanspruchs 7 gelöst. Vorteilhafte Ausgestaltungen mit zweckmäßigen und nichttrivialen Weiterbildungen der Erfindung sind in den übrigen Ansprüchen angegeben.

Der erste Aspekt der Erfindung betrifft eine Anzeigevorrichtung eines Kraftwagens, mit wenigstens einem Anzeigeelement, mittels welchem zumindest ein Wert anzeigbar ist und welches zumindest ein Leuchtelement zum Einstellen einer Anzeigehelligkeit des Anzeigenelements aufweist. Die Anzeigevorrichtung umfasst ferner eine Erfassungseinrichtung mit wenigstens einem Erfassungselement zum Erfassen einer Umgebungshelligkeit einer Umgebung des Anzeigeelements. Dabei ist die Anzeigehelligkeit mittels des Leuchtelements in Abhängigkeit von der erfassten Umgebungshelligkeit einstellbar.

Erfindungsgemäß ist die Erfassungseinrichtung dazu ausgelegt, bei einem Erfassen einer Änderung der Umgebungshelligkeit wenigstens eine von dem Einstellen der Anzeigehelligkeit unterschiedliche Funktion des Kraftwagens zu bewirken. Mit anderen Worten dient die Erfassungseinrichtung nicht nur dazu, die Anzeigehelligkeit in Abhängigkeit von der erfassten Umgebungshelligkeit einzustellen, sondern auch in Abhängigkeit von der Änderung der Umgebungshelligkeit die wenigstens eine, von dem Einstellen der Anzeigehelligkeit unterschiedliche Funktion des Kraftwagens zu bewirken. Dadurch kann auf zusätzliche und insbesondere mechanische Betätigungselemente zum Bewirken der Funktion verzichtet werden, welche einen zusätzlichen Entwicklungs- und Herstellungsaufwand erfordern würden. In der Folge können die Kosten der Anzeigevorrichtung besonders gering gehalten werden.

Derartige mechanische Betätigungselemente weisen auch einen gewissen Bauraumbedarf auf, welcher entsprechend freigehalten werden muss, wenn ein solches mechanisches Betätigungselement verwendet wird. Das Vorsehen dieses zusätzlichen Bauraums kann bei der erfindungsgemäßen Anzeigevorrichtung vermieden werden. Darüber hinaus unterliegen mechanische Betätigungselemente einem mechanischen Verschleiß, was bei der Verwendung der Erfassungseinrichtung zum Bewirken der Funktion ebenso vermieden ist.

Ferner muss keine Übertragungsmechanik vorgesehen werden, beispielsweise um eine Betätigung eines mechanischen Betätigungselements an einen entsprechenden Schalter zu übertragen. Des Weiteren kann es bei der Betätigung von mechanischen Betätigungselementen zu Geräuschen kommen, was bei der erfindungsgemäßen Anzeigevorrichtung ebenso vermieden ist. Im Gegensatz dazu kann beispielsweise eine akustische Rückmeldung über das Bewirken der Funktion beispielsweise an den Fahrer des Kraftwagens beliebig eingestellt werden. Außerdem kann das Gewicht der Anzeigevorrichtung gering gehalten werden, da auf gewichtsintensive, mechanische Betätigungselemente sowie zugeordnete Verkabelungen, über welche die Funktion zu bewirken ist, verzichtet werden kann.

In vorteilhafter Ausgestaltung der Erfindung umfasst die von dem Einstellen der Anzeigehelligkeit unterschiedliche Funktion ein Verändern des durch das Anzeigeelement anzeigbaren Werts. Mit anderen Worten wird beim Bewirken der Funktion der Wert verändert. Dies ist insofern vorteilhaft, als die Funktion, die mittels des an der Anzeigevorrichtung angeordneten Erfassungselements bewirkbar ist, örtlich auch der Anzeigevorrichtung zugeordnet ist.

Vorzugsweise umfasst die Funktion ein Nullstellen des durch das Anzeigeelement anzeigbaren Werts eines Kilometerstands des Kraftwagens, wobei es sich bei dem Kilometerstand vorzugsweise um einen sogenannten Tageskilometerstand handelt. Der Wert des Tageskilometerstands gibt dabei eine Strecke beispielsweise in Kilometern an, über welche der Kraftwagen seit letztmaligem Bewirken der Funktion, d.h. seit letztmaligem Rückstellen des Werts bewegt wurde. Die Funktion kann dabei ergonomisch vorteilhaft bewirkt werden, da das Leuchtelement an ergonomisch vorteilhaften Stellen der Anzeigevorrichtung positioniert werden kann.

Erfindungsgemäß ist die Erfassungseinrichtung dazu ausgelegt, die von dem Einstellen der Anzeigehelligkeit unterschiedliche Funktion in Abhängigkeit von einer mittels der Erfassungseinrichtung erfassten Verringerung als die Veränderung der Umgebungshelligkeit zu bewirken. Dadurch ist ein für den Fahrer des Kraftwagens besonders einfaches Bewirken der Funktion geschaffen, da er lediglich das Erfassungselement, bei welchem es sich beispielsweise um eine Fotodiode oder einen Fototransistor handelt, zumindest teilweise zu überdecken hat. Dazu kann der Fahrer beispielsweise seinen Finger über oder auf das Erfassungselement halten.

Es hat sich als vorteilhaft gezeigt, wenn die Erfassungseinrichtung dazu ausgelegt ist, die vom Einstellen der Anzeigehelligkeit unterschiedliche Funktion zu bewirken, wenn sich die Umgebungshelligkeit innerhalb einer vorgebbaren Zeitdauer um einen vorgebbaren Betrag verringert. Dadurch ist es möglich, das Bewirken der Funktion von dem Bewirken der Veränderung der Anzeigehelligkeit, so dass beispielsweise auch nur dann die Funktion bewirkt wird, wenn dies vom Fahrer gewünscht ist, ohne die Anzeigehelligkeit zu verändern.

Kommt es somit zu einer plötzlichen, mittels des Erfassungselements erfassten Abdunkelung, wobei die Umgebungshelligkeit innerhalb einer kurzen Zeitdauer um einen relativ großen Betrag abnimmt, da der Fahrer das Erfassungselement überdeckt, so wird die vom Einstellen der Anzeigehelligkeit unterschiedliche Funktion bewirkt. Kommt es jedoch zu einer demgegenüber weniger schnellen Abdunkelung, wobei die Umgebungshelligkeit über eine längere Zeitdauer und/oder um einen demgegenüber geringeren Betrag verringert wird, da der Kraftwagen beispielsweise in einen Tunnel eingefahren wird, so wird - ohne die vom Einstellen der Anzeigehelligkeit unterschiedliche Funktion zu bewirken - die Anzeigehelligkeit eingestellt bzw. verändert und an die nun dunkleren Umgebungsbedingungen angepasst. Dadurch werden für den Fahrer angenehme Beleuchtungsbedingungen geschaffen, ohne die vom Einstellen der Anzeigehelligkeit unterschiedliche Funktion unerwünschterweise zu bewirken.

In weiterer vorteilhafter Ausgestaltung der Erfindung ist die Erfassungseinrichtung dazu ausgelegt, die von dem Einstellen der Anzeigehelligkeit unterschiedliche Funktion bei einer ersten Art der Veränderung der Umgebungshelligkeit und wenigstens eine von der Funktion und von dem Einstellen der Anzeigehelligkeit unterschiedliche, zweite Funktion bei einer von der ersten Art der Veränderung der Umgebungshelligkeit unterschiedlichen, zweiten Art der Veränderung der Umgebungshelligkeit zu bewirken. Dadurch ist ein besonders großer Funktionserfüllungsumfang der Erfassungseinrichtung geschaffen, da sie nicht nur dazu dient, die Anzeigehelligkeit an die Umgebungshelligkeit anzupassen, sondern auch dazu genutzt wird, die zwei voneinander unterschiedlichen Funktionen zu bewirken.

Bei der ersten Funktion kann es sich beispielsweise um das Nullstellen des Werts des Kilometerstands, insbesondere des Tageskilometerstands, handeln. Bei der zweiten Funktion kann es sich beispielsweise um ein Nullstellen eines Werts handeln, welcher einen Kraftstoffdurchschnittsverbrauch des Kraftwagens, eine Durchschnittsgeschwindigkeit des Kraftwagens und/oder einen anderweitigen Wert charakterisiert. Bei der zweiten Funktion kann es sich auch um eine anderweitige, von dem Einstellen der Anzeigehelligkeit und von der ersten Funktion unterschiedliche Funktion handeln. Hierbei kommt der Erfassungseinrichtung nicht nur eine Doppelfunktion sondern gar eine Dreifachfunktion zu. Durch das Ermöglichen einer solchen Mehrfachfunktion kann auf mechanische Betätigungselemente verzichtet werden, so dass die Anzeigevorrichtung besonders kostengünstig hergestellt und montiert werden kann. Darüber hinaus kann so das Gewicht der Anzeigevorrichtung gering gehalten werden.

Um das Bewirken der beiden, jeweils von dem Einstellen der Anzeigehelligkeit unterschiedlichen Funktionen deutlich voneinander zu trennen, ist bei einer weiteren Ausführungsform der Erfindung vorgesehen, dass sich die Arten der Veränderung der Umgebungshelligkeit hinsichtlich einer mittels der Erfassungseinrichtung innerhalb einer vorgebbaren Zeitdauer erfassten Häufigkeit einer Verringerung als die Veränderung der Umgebungshelligkeit und/oder hinsichtlich einer Zeitdauer, innerhalb welcher die Erfassungseinrichtung eine Unterschreitung eines vorgebbaren Schwellenwerts durch die Umgebungshelligkeit erfasst, voneinander unterscheiden. Mit anderen Worten, soll beispielsweise die vom Einstellen der Anzeigehelligkeit unterschiedliche, erste Funktion bewirkt werden, so wird die Umgebungshelligkeit innerhalb der vorgebbaren Zeitdauer weniger häufig verdunkelt, als wenn die vom Einstellen der Anzeigehelligkeit und von der ersten Funktion unterschiedliche, zweite Funktion bewirkt werden soll. Wird beispielsweise die Umgebungshelligkeit innerhalb der vorgebbaren Zeitdauer um einen vorgebbaren Betrag einmalig verringert, so wird die erste Funktion bewirkt. Wird die Umgebungshelligkeit jedoch innerhalb der vorgebbaren Zeitdauer häufiger, d.h. wenigstens zweimal um den vorgebbaren Betrag verringert, wobei die Umgebungshelligkeit zwischen dem jeweiligen Verringern erhöht wird, indem beispielsweise eine Überdeckung des Erfassungselements aufgehoben wird, so wird die zweite Funktion bewirkt.

Zusätzlich oder alternativ dazu kann vorgesehen sein, dass die erste Funktion bewirkt wird, wenn mittels der Erfassungseinrichtung erfasst wird, dass die Umgebungshelligkeit innerhalb einer vorgebbaren, ersten Zeitdauer den vorgebbaren Schwellenwert unterschreitet. Wird mittels der Erfassungseinrichtung erfasst, dass die Umgebungshelligkeit den vorgebbaren Schwellenwert über eine vorgebbare, zweite Zeitdauer, welche größer ist als die erste Zeitdauer, unterschreitet, so wird die zweite Funktion bewirkt.

Um Fehllauslösungen der von dem Einstellen der Anzeigehelligkeit unterschiedlichen Funktion bzw. Funktionen besonders sicher zu vermeiden, kann wenigstens ein weiteres Kriterium vorgesehen werden, bei dessen Erfülltsein die vom Einstellen der Anzeigehelligkeit unterschiedliche Funktion bzw. Funktionen bewirkt wird bzw. werden, wenn es zu einer mittels des Leuchtelements erfassten und durch den Fahrer bewirkten Veränderung der Umgebungshelligkeit kommt.

Der zweite Aspekt der Erfindung betrifft ein Verfahren zum Betreiben einer Anzeigevorrichtung eines Kraftwagens, insbesondere eines Personenkraftwagens, mit wenigstens einem Anzeigeelement, mittels welchem zumindest ein Wert anzeigbar ist und welches zumindest ein Leuchtelement zum Einstellen einer Anzeigehelligkeit des Anzeigeelements aufweist. Die Anzeigevorrichtung umfasst auch eine Erfassungseinrichtung mit wenigstens einem Erfassungselement zum Erfassen einer Umgebungshelligkeit einer Umgebung des Anzeigeelements. Die Anzeigehelligkeit ist dabei mittels des Leuchtelements in Abhängigkeit von der erfassten Umgebungshelligkeit einstellbar,

Zur Realisierung einer kostengünstigen Herstellung und eines geringen Gewichts der Anzeigevorrichtung ist es erfindungsgemäß vorgesehen, dass bei einem Erfassen der Änderung der Umgebungshelligkeit mittels der Erfassungseinrichtung wenigstens eine von dem Einstellen der Anzeigehelligkeit unterschiedliche Funktion des Kraftwagens bewirkt wird.

Vorteilhafte Ausgestaltungen des ersten Aspekts der Erfindung sind als vorteilhafte Ausgestaltungen des zweiten Aspekts der Erfindung anzusehen.

Das erfindungsgemäße Verfahren ermöglicht es, auf mechanische Betätigungselemente zu verzichten und somit mit der Verwendung von mechanischen Betätigungselementen einhergehende Nachteile wie Bauraumbedarf, Gewicht, Verschleiß, Geräuschentwicklung und/oder dergleichen zu vermeiden, da das ohnehin vorgesehene Leuchtelement zum Bewirken der Funktion verwendet wird.

Zur Erfindung gehört auch ein Kraftwagen mit einer solchen Anzeigevorrichtung, dessen Kosten aufgrund der kostengünstigen Anzeigevorrichtung besonders gering gehalten werden können.

Weitere Vorteile, Merkmale und Einzelheiten der Erfindung ergeben sich aus der nachfolgenden Beschreibung eines bevorzugten Ausführungsbeispiels sowie anhand der Zeichnung. Die vorstehend in der Beschreibung genannten Merkmale und Merkmalskombinationen sowie die nachfolgend in der Figurenbeschreibung genannten und/oder in den Fig. alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Die Zeichnung zeigt in:
- Fig. 1: eine schematische Vorderansicht einer Anzeigevorrichtung eines Personenkraftwagens gemäß dem Stand der Technik; und
- Fig. 2: eine schematische Vorderansicht einer weiteren Ausführungsform der Anzeigevorrichtung gemäß Fig. 1, bei welcher zum Einstellen einer Anzeigehelligkeit von jeweiligen Anzeigeelementen der Anzeigevorrichtung ein Erfassungselement verwendet wird, mittels welchem eine Umgebungshelligkeit einer Umgebung der Anzeigeelemente erfassbar ist.

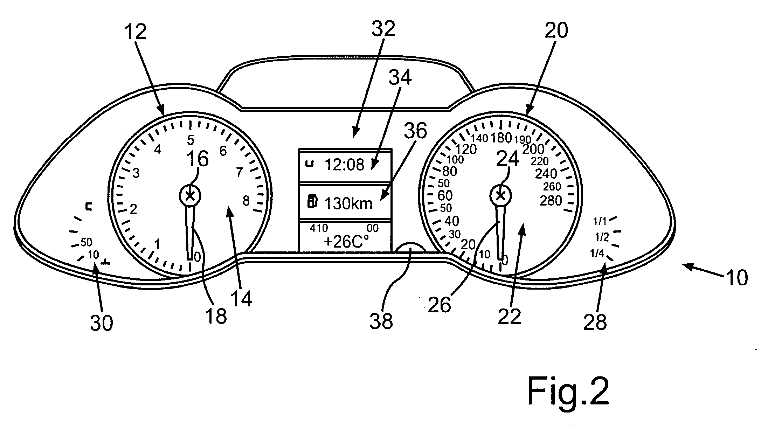

Fig. 2 zeigt eine Anzeigevorrichtung 10 eines Personenkraftwagens, wobei in Fig. 1 und 2 gleiche Bezugszeichen gleiche Elemente bezeichnen. Die Anzeigevorrichtung 10 gemäß Fig. 2 unterscheidet sich nun dahingehend von der Anzeigevorrichtung 10 gemäß Fig. 1, dass die Erfassungseinrichtung dazu ausgelegt ist, bei einem Erfassen einer Änderung der Umgebungshelligkeit wenigstens eine von dem Einstellen der Anzeigehelligkeit unterschiedliche Funktion des Kraftwagens zu bewirken. Bei dieser vom Einstellen der Anzeigehelligkeit unterschiedlichen Funktion handelt es sich vorliegend um das Nullstellen des Werts des Tageskilometerstands, welcher beispielsweise durch das fünfte Anzeigeelement 32 anzeigbar ist.

Der Erfassungseinrichtung, insbesondere dem Erfassungselement 38, kommt dabei eine Doppelfunktion zu, da es einerseits zum Einstellen der Anzeigehelligkeit in Abhängigkeit von der Umgebungshelligkeit und andererseits zum Bewirken der davon unterschiedlichen Funktion verwendet wird.

Wie anhand von Fig. 2 erkennbar ist, kann aufgrund dieser Doppelfunktion auf das mechanische Betätigungselement 40 verzichtet werden, so dass auch mit der Verwendung des Betätigungselements 40 einhergehende Nachteile wie Bauraumbedarf, Gewicht, Geräuschentwicklung, Verschleiß, notwendige Verkabelung des mechanischen Betätigungselements 40 etc. vermieden können.

Das Erfassungselement 38, welches beispielsweise eine Fotodiode oder ein Fototransistor ist, wird als Taster zum Bewirken der Funktion verwendet. Dabei ist das Erfassungselement 38 so ausgelegt, dass bei schneller Abdunkelung, d.h. bei schneller Verringerung der Umgebungshelligkeit das Nullstellen des Werts des Tageskilometerstands bewirkt wird. Zu einer solchen schnellen Abdunkelung kommt es beispielsweise, wenn der Fahrer des Personenkraftwagens mit seinem Finger das Erfassungselement 38 überdeckt und beispielsweise seinen Finger über das Erfassungselement 38 legt. Dabei kann der Fahrer seinen Finger auf das Erfassungselement 38 oder auf eine das Erfassungselement 38 abdeckende Scheibe der Anzeigevorrichtung 10 legen, so dass durch das Erfassungselement 38 ein Taster geschaffen ist, welcher nach Art eines berührungsempfindlichen Betätigungselements betätigbar ist.

Um auf diese Möglichkeit, die Funktion mittels des Erfassungselements 38 zu bewirken, hinzuweisen, kann das Erfassungselement 38 mit einer entsprechenden Beschriftung versehen sein. Um die Funktion für den Fahrer ergonomisch vorteilhaft bewirken zu können, ist dabei das Betätigungselement 40 durch das Erfassungselement 38 ersetzt. Mit anderen Worten ist das Erfassungselement 38 an der Stelle des Betätigungselements 40 angeordnet.

Die zuvor geschilderte, schnelle Abdunkelung, die zum Bewirken der Funktion führt, ist beispielsweise dadurch definiert, dass die Umgebungshelligkeit innerhalb einer vorgebbaren Zeitdauer um einen vorgebbaren Betrag verringert wird. Hierbei handelt es sich um einen Gradienten, welcher die Schnelligkeit der Verringerung bzw. Abnahme der Umgebungshelligkeit charakterisiert. Kommt es zu der Verringerung der Umgebungshelligkeit um den vorgebbaren Betrag jedoch in einer entsprechend längeren Zeitdauer und/oder kommt es innerhalb der vorgebbaren Zeitdauer zu einer Verringerung der Umgebungshelligkeit um einen entsprechend geringeren Betrag, so dass der Gradient der Verringerung der Umgebungshelligkeit geringer ist, als es für das Bewirken der Funktion nötig ist, so wird auf eine anderweitige, nicht durch den Fahrer des Personenkraftwagens bewirkte Abdunkelung rückgeschlossen. Dann wird die Funktion nicht bewirkt, sondern die Anzeigehelligkeit wird eingestellt, d.h. verändert und an die veränderte Umgebungshelligkeit angepasst wird.

Um eine Fehlauslösung der Funktion besonders sicher zu vermeiden, kann auch wenigstens ein weiteres Kriterium vorgesehen werden, bei dessen Erfülltsein zusammen mit dem Vorliegen der schnellen Abdunkelung die Funktion bewirkt wird.

Erfolgt die schnelle Abdunkelung innerhalb einer vorgebbaren Zeitdauer mehrmals und/oder wird die schnelle Abdunkelung über eine vorgebbare Zeitdauer durchgeführt, d.h. wird mittels der Erfassungseinrichtung ein Unterschreiten eines vorgebbaren Schwellenwerts durch die Umgebungshelligkeit über eine vorgebbare Zeitdauer erfasst, so kann dadurch beispielsweise eine zweite Funktion bewirkt werden, welche von der ersten Funktion und von dem Einstellen der Anzeigehelligkeit unterschiedlich ist. Dadurch kann beispielsweise ein weiterer, mittels der Anzeigevorrichtung 10 anzeigbarer Wert verändert, insbesondere auf Null gestellt, werden.

## Patentansprüche

1. Anzeigevorrichtung (10) eines Kraftwagens, mit wenigstens einem Anzeigeelement (12, 20, 28, 30, 32), mittels welchem zumindest ein Wert anzeigbar ist und welches zumindest ein Leuchtelement zum Einstellen einer Anzeigehelligkeit des Anzeigeelements (12, 20, 28, 30, 32) aufweist, und mit einer Erfassungseinrichtung, welche wenigstens ein Erfassungselement (38) zum Erfassen einer Umgebungshelligkeit einer Umgebung des Anzeigeelements (12, 20, 28, 30, 32) umfasst, wobei die Anzeigehelligkeit mittels des Leuchtelements in Abhängigkeit von der erfassten Umgebungshelligkeit einstellbar ist, und wobei die Erfassungseinrichtung dazu ausgelegt ist, bei einem Erfassen einer Änderung der Umgebungshelligkeit wenigstens eine von dem Einstellen der Anzeigehelligkeit unterschiedliche Funktion des Kraftwagens zu bewirken, **dadurch gekennzeichnet, dass**
die Erfassungseinrichtung dazu ausgelegt ist, die von dem Einstellen der Anzeigehelligkeit unterschiedliche Funktion in Abhängigkeit von einer mittels der Erfassungseinrichtung erfassten Verringerung als die Veränderung der Umgebungshelligkeit zu bewirken.

2. Anzeigevorrichtung (10) nach Anspruch 1,
**dadurch gekennzeichnet, dass**
die von dem Einstellen der Anzeigehelligkeit unterschiedliche Funktion ein Verändern, insbesondere ein Nullstellen, des durch das Anzeigeelement (12, 20, 28, 30, 32) anzeigbaren Werts, insbesondere eines Kilometerstands des Kraftwagens, umfasst.

3. Anzeigevorrichtung (10) nach einem der vorhergehenden Ansprüche,
**dadurch gekennzeichnet, dass**
die Erfassungseinrichtung dazu ausgelegt ist, die von dem Einstellen der Anzeigehelligkeit unterschiedliche Funktion zu bewirken, wenn sich die Umgebungshelligkeit innerhalb einer vorgebbaren Zeitdauer um einen vorgebbaren Betrag verringert.

4. Anzeigevorrichtung (10) nach einem der vorhergehenden Ansprüche,
**dadurch gekennzeichnet, dass**
die Erfassungseinrichtung dazu ausgelegt ist, die von dem Einstellen der Anzeigehelligkeit unterschiedliche Funktion bei einer ersten Art der Veränderung der Umgebungshelligkeit und wenigstens eine von der Funktion und von dem Einstellen der Anzeigehelligkeit unterschiedliche, zweite Funktion bei einer von der ersten Art der Veränderung der Umgebungshelligkeit unterschiedlichen, zweiten Art der Veränderung der Umgebungshelligkeit zu bewirken.

5. Anzeigevorrichtung (10) nach Anspruch 4,
**dadurch gekennzeichnet, dass**
sich die Arten der Veränderung der Umgebungshelligkeit hinsichtlich einer mittels der Erfassungseinrichtung innerhalb einer vorgebbaren Zeitdauer erfassten Häufigkeit einer Verringerung als die Veränderung der Umgebungshelligkeit und/oder hinsichtlich einer Zeitdauer, innerhalb welcher die Erfassungseinrichtung eine Unterschreitung eines vorgebbaren Schwellenwerts durch die Umgebungshelligkeit erfasst, voneinander unterscheiden.

6. Kraftwagen mit einer Anzeigevorrichtung (10) nach einem der vorhergehenden Ansprüche.

7. Verfahren zum Betreiben einer Anzeigevorrichtung (10) eines Kraftwagens, mit wenigstens einem Anzeigeelement (12, 20, 28, 30, 32), mittels welchem zumindest ein Wert anzeigbar ist und welches zumindest ein Leuchtelement zum Einstellen einer Anzeigehelligkeit des Anzeigeelements (12, 20, 28, 30, 32) aufweist, und mit einer Erfassungseinrichtung, welche wenigstens ein Erfassungselement (38) zum Erfassen einer Umgebungshelligkeit einer Umgebung des Anzeigeelements (12, 20, 28, 30, 32) umfasst, wobei die Anzeigehelligkeit mittels des Leuchtelements in Abhängigkeit von der erfassten Umgebungshelligkeit einstellbar ist, und wobei bei einem Erfassen einer Änderung der Umgebungshelligkeit mittels der Erfassungseinrichtung wenigstens eine von dem Einstellen der Anzeigehelligkeit unterschiedliche Funktion des Kraftwagens bewirkt wird,
**dadurch gekennzeichnet, dass**
die von dem Einstellen der Anzeigehelligkeit unterschiedliche Funktion in Abhängigkeit von einer mittels der Erfassungseinrichtung erfassten Verringerung als die Veränderung der Umgebungshelligkeit bewirkt wird.

## Claims

1. Display device (10) of a motor vehicle, with at least one display element (12, 20, 28, 30, 32), by means of which at least one value can be displayed and which has at least one illumination element for adjusting the display luminosity of the display element (12, 20, 28, 30, 32), and with a detection device comprising at least one detection element (38) for detecting an ambient luminosity surrounding the display element (12, 20, 28, 30, 32), wherein the display luminosity is adjustable by means of the illumination element dependent on the detected ambient luminosity, and wherein the detection device is designed so that when a change in the ambient luminosity is detected, at least one function of the motor vehicle that is different from adjusting the display luminosity is effected, **characterised in that** the detection device is designed to effect the function that is different from the adjustment of the display luminosity dependent on a reduction detected by means of the detection device as the change in the ambient luminosity.

2. Display device (10) according to claim 1, **characterised in that** the function that is different from the adjustment of the display luminosity comprises a change in, in particular a zeroing of, the value displayable by the display element (12, 20, 28, 30, 32), in particular an odometer reading of the motor vehicle.

3. Display device (10) according to one of the above claims, **characterised in that** the detection device is designed to effect the function that is different from adjustment of the display luminosity if the ambient luminosity reduces by a predefinable amount within a predefinable time

4. Display device (10) according to any of the above claims, **characterised in that** the detection device is designed to effect the function that is different from adjustment of the display luminosity in the event of a first type of change in the ambient luminosity and at least one second function that is different from the function and from the adjustment of the display device in the event of a second type of change in the ambient luminosity that is different from the first type of change in the ambient luminosity.

5. Display device (10) according to claim 4, **characterised in that** the types of change in the ambient luminosity differ from one another in respect of a frequency of a reduction detected by means of the detection device within a predefinable time as the change in ambient luminosity and/or in respect of a time within which the detection device detects that the ambient luminosity has fallen below a predefinable threshold value.

6. Motor vehicle with a display device (10) according to one of the preceding claims.

7. Method for operating a display device (10) of a motor vehicle, with at least one display element (12, 20, 28, 30, 32), by means of which at least one value can be displayed and which has at least one illumination element for adjusting the display luminosity of the display element (12, 20, 28, 30, 32), and with a detection device comprising at least one detection element (38) for detecting an ambient luminosity surrounding the display element (12, 20, 28, 30, 32), wherein the display luminosity is adjustable by means of the illumination element dependent on the detected ambient luminosity and wherein when a change in the ambient luminosity is detected by means of the detection device at least one function of the motor vehicle that is different from adjusting the display luminosity is effected, **characterised in that** the function that is different from the adjustment of the display luminosity is effected dependent on a reduction detected by means of the detection device as the change in the ambient luminosity.

## Revendications

1. Dispositif indicateur (10) pour un véhicule comportant au moins un élément afficheur (12, 20, 28, 30, 32) au moyen duquel au moins une valeur est affichée et qui comporte au moins un élément d'éclairage pour le réglage d'un éclairage d'affichage des éléments afficheurs (12, 20, 28, 30, 32) et avec un dispositif de détection qui se compose au moins d'un élément de détection (38) pour détecter une lumière ambiante du milieu environnant des éléments afficheurs (12, 20, 28, 30, 32), dans lequel l'éclairage d'affichage est réglé au moyen de l'élément d'éclairage en fonction de la lumière ambiante détectée et dans lequel le dispositif de détection est conçu en outre de telle façon que lors d'une détection d'une modification de la lumière ambiante, on déclenche au moins une fonction du véhicule différente du réglage de la lumière d'affichage **caractérisé en ce que** le dispositif de détection est conçu en outre pour déclencher au moins une fonction différente du réglage de la lumière d'affichage en fonction d'une réduction détectée par le dispositif de détection comme une modification de la lumière ambiante.

2. Dispositif indicateur (10) selon la revendication 1 **caractérisé en ce que** la fonction différente du réglage de la lumière d'affichage comprend une modification, notamment une mise à zéro, de la valeur affichable par les éléments afficheurs (12, 20, 28, 30, 32) en particulier d'un kilométrage du véhicule.

3. Dispositif indicateur (10) selon l'une des revendications précédentes **caractérisé en ce que** le dispositif de détection est conçu en outre pour déclencher la fonction différente du réglage de la lumière d'affichage lorsque la lumière ambiante se réduit d'une valeur prédéterminée pendant une durée prédéterminée.

4. Dispositif indicateur (10) selon l'une des revendications précédentes **caractérisé en ce que** le dispositif de détection est conçu en outre pour déclencher la fonction différente du réglage de la lumière d'affichage en présence d'un premier type de modification de la lumière ambiante et pour déclencher une deuxième fonction différente du réglage de la lumière d'affichage et différente de la première fonction en présence d'un deuxième type de modification de la lumière ambiante différent du premier type de modification de la lumière ambiante.

5. Dispositif indicateur (10) selon la revendication 4 **caractérisé en ce que** les types de modification de la lumière ambiante se distinguent par une fréquence d'une réduction, détectée au moyen du dispositif de détection à l'intérieur d'une durée prédéterminée, en tant que modification de la lumière ambiante et/ou par une durée, à l'intérieur de laquelle le dispositif de détection détecte une lumière ambiante devenant inférieure à une valeur de seuil prédéterminée.

6. Véhicule équipé d'un dispositif indicateur (10) selon l'une des revendications précédentes.

7. Procédé pour actionner un dispositif indicateur (10) d'un véhicule, avec au moins un élément afficheur (12, 20, 28, 30, 32), par l'intermédiaire duquel au moins une valeur est affichable et lequel présente au moins un élément d'éclairage pour établir un éclairage de l'élément afficheur (12, 20, 28, 30, 32) et comporte un dispositif de détection qui se compose d'au moins un élément de détection (38) pour détecter une lumière ambiante dans l'environnement de l'élément afficheur (12, 20, 28, 30, 32), par lequel la lumière d'affichage au moyen de l'élément d'éclairage est réglable en fonction de la lumière ambiante détectée et par lequel lors d'une détection d'une modification de la lumière ambiante au moyen du dispositif de détection, on déclenche au moins une fonction du véhicule différente du réglage de la lumière d'affichage,
**caractérisé en ce que**
l'on déclenche au moins une fonction différente du réglage de la lumière d'affichage en fonction d'une réduction de la lumière ambiante détectée au moyen du dispositif de détection comme une modification de la lumière ambiante.
